(19) **Europäisches Patentamt / European Patent Office / Office européen des brevets**

(11) **EP 2 515 130 B1**

(12) **FASCICULE DE BREVET EUROPEEN**

(45) Date de publication et mention de la délivrance du brevet:
**30.10.2013 Bulletin 2013/44**

(51) Int Cl.:
**G01R 33/09** (2006.01)   **H03B 15/00** (2006.01)

(21) Numéro de dépôt: **12163832.4**

(22) Date de dépôt: **12.04.2012**

(54) **Detecteur d'oscillations**

Oszillationsdetektor

Oscillation detector

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.04.2011 FR 1153424**

(43) Date de publication de la demande:
**24.10.2012 Bulletin 2012/43**

(73) Titulaire: **Commissariat à l'Énergie Atomique et aux Énergies Alternatives**
**75015 Paris (FR)**

(72) Inventeurs:
- **Quinsat, Michael**
  **38000 Grenoble (FR)**
- **Cyrille, Marie- Claire**
  **38650 Sinard (FR)**
- **Ebels, Ursula**
  **38100 Grenoble (FR)**
- **Michel, Jean-Philippe**
  **38600 Fontaine (FR)**

- **Pelissier, Michaël**
  **38000 Grenoble (FR)**
- **Villard, Patrick**
  **38700 La Tronche (FR)**
- **Zarudniev, Mykhailo**
  **04213 Kiev (UA)**

(74) Mandataire: **Colombo, Michel et al**
**Brevinnov**
**310 avenue Berthelot**
**69008 Lyon (FR)**

(56) Documents cités:
**US-A1- 2008 150 643**

- **ZARUDNIEV M ET AL: "Spintorque Oscillator Characteristics in Coupled Networks", HARDWARE AND SOFTWARE IMPLEMENTATION AND CONTROL OF DISTRIBUTED MEMS (DMEMS), 2010 FIRST WORKSHOP ON, IEEE, PISCATAWAY, NJ, USA, 28 juin 2010 (2010-06-28), pages 20-23, XP031711118, ISBN: 978-1-4244-7222-2**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

L'invention a pour objet un détecteur et un procédé de détection d'oscillations, à l'intérieur d'une bande de fréquences autour d'une fréquence $f_t$, dans un signal électrique radiofréquence e(t) reçu.

Il existe de nombreuses situations où il est utile de savoir si des oscillations à l'intérieur d'une bande de fréquences autour d'une fréquence $f_t$ donnée sont présentes dans un signal radiofréquence. En effet, la présence ou l'absence d'oscillations à l'intérieur de cette bande de fréquence peut coder une information. Pour décoder cette information, il faut donc être capable de détecter la présence ou l'absence des oscillations à l'intérieur de cette bande de fréquences. Par exemple, des détecteurs d'oscillations sont utilisés dans des domaines aussi variés que:

- les télécommunications,
- le contrôle et la commande de moteurs,
- la protection de lignes électriques, et
- des détecteurs de proximité.

Classiquement, les détecteurs d'oscillations sont réalisés à partir de composants électroniques tels que des condensateurs, des résistances ou autres. Pour un exemple de mode de réalisation d'un détecteur connu d'oscillations, il est possible de se référer à la demande de brevet US2003193325.

Tous ces détecteurs connus comportent une borne d'acquisition sur laquelle est reçu le signal e(t).

Tous ces détecteurs connus ont en commun d'être encombrants et, souvent, complexes.

De l'état de la technique est également connu de :

- US2008/150643, et
- Zarudniev M et AI : « Spintorque Oscillator Characteristics in coupled Networks », Hardware and Software implementation and control of distributed MEMS (DMEMS), 2010 First workshop on, IEEE, Piscataway, NJ, USA, 28 juin 2010, pages 23-23.

L'invention vise à remédier à cet inconvénient en proposant un détecteur moins encombrant.

Elle a donc pour objet un détecteur conforme à la revendication 1.

Le détecteur ci-dessus utilise principalement un dispositif magnétorésistif dont l'électrode de sortie est raccordée à un comparateur apte à distinguer l'état synchronisé de l'état non synchronisé du dispositif magnétorésistif. Les dispositifs magnétorésistifs sont particulièrement peu encombrants. En effet, ils présentent généralement une section transversale inférieure à 10 $\mu m^2$ et une épaisseur de quelques micromètres (inférieure à 10 pm). Ainsi, grâce à l'utilisation du dispositif magnétorésistif dans le détecteur ci-dessus, l'encombrement du détecteur est réduit.

Les modes de réalisation de ce détecteur peuvent comporter une ou plusieurs des caractéristiques des revendications dépendantes.

Ces modes de réalisation du détecteur présentent en outre les avantages suivants :

- utiliser la puissance des composantes basses fréquences pour discriminer l'état synchronisé de l'état non synchronisé permet de réaliser simplement le détecteur, et
- utiliser plusieurs oscillateurs radiofréquences raccordés en parallèle entre les bornes communes d'entrée et de sortie permet d'amplifier l'amplitude du signal oscillant et donc d'accroître la sensibilité du détecteur.

L'invention a également pour objet un procédé de détection d'oscillations conforme à la revendication 7.

Les modes de réalisation de ce procédé peuvent comporter une ou plusieurs des caractéristiques des revendications dépendantes de procédé.

L'invention sera mieux comprise à la lecture de la description qui va suivre, donnée uniquement à titre d'exemple non limitatif et faite en se référant aux dessins sur lesquels :

- la figure 1 est une illustration schématique d'un détecteur d'oscillations à la fréquence $f_t$;
- la figure 2 est un chronogramme partiel d'un signal comportant des oscillations à la fréquence $f_t$;
- la figure 3 est une illustration schématique d'un oscillateur radiofréquence utilisé dans le détecteur de la figure 1 ;
- les figures 4 à 5 sont des parties respectives d'un spectre de fréquences illustrant différents aspects du signal oscillant produit par l'oscillateur radiofréquence de la figure 3 ;
- les figures 6 et 7 sont des illustrations schématiques d'un comparateur du détecteur de la figure 1 ;
- la figure 8 est un organigramme d'un procédé de détection à l'aide du détecteur de la figure 1 ;
- la figure 9 est un autre mode de réalisation d'un détecteur d'oscillations à la fréquence $f_t$ ;
- la figure 10 est un autre mode de réalisation d'un oscillateur radiofréquence utilisable dans le détecteur de la figure 1 ou 9.

Dans ces figures, les mêmes références sont utilisées pour désigner les mêmes éléments.

Dans la suite de cette description, les caractéristiques et fonctions bien connues de l'homme du métier ne sont pas décrites en détail.

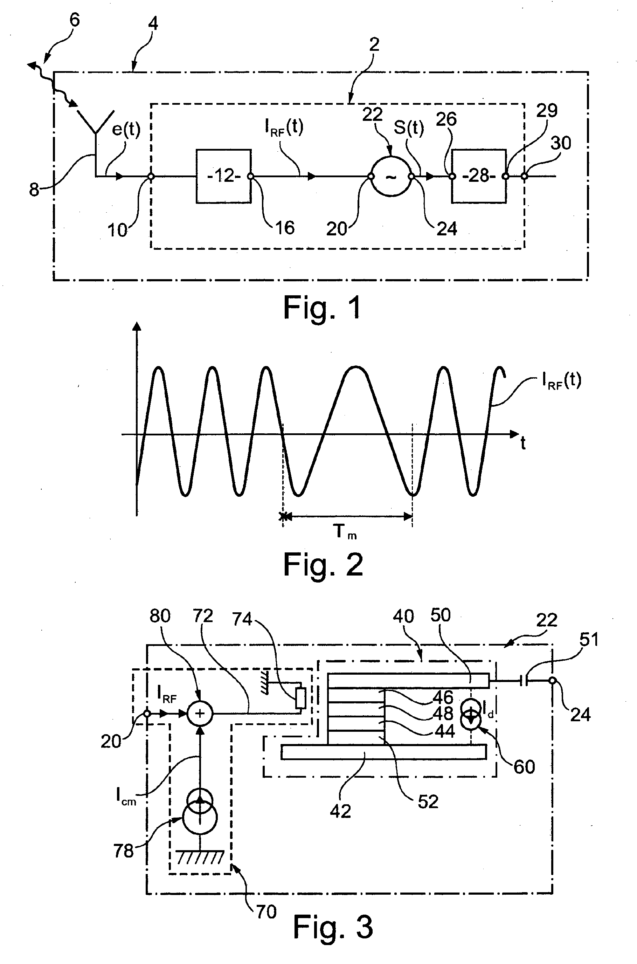

La figure 1 représente un détecteur 2 d'oscillations à l'intérieur d'une bande de fréquences autour de la fréquence $f_t$ dans un signal électrique e(t). Par exemple, la bande de fréquences est centrée autour de la fréquence $f_t$. Le signal e(t) est un courant électrique. Ici, le détecteur 2 est décrit dans le cas particulier où il fait partie d'un appareil 4 propre à recevoir par l'intermédiaire d'une liaison sans fil 6 le signal électrique. Par exemple, l'appareil 4 est un téléphone portable et la liaison 6 est une liaison radio.

L'appareil 4 est équipé d'une antenne 8 pour établir la liaison sans fil 6. L'antenne 8 convertit le signal radio en un signal électrique e(t) qui est transmis à une borne 10 d'acquisition du signal électrique du détecteur 2. Entre l'antenne 8 et la borne 10, l'appareil 4 peut comporter différents blocs électroniques qui n'ont pas été représentés pour simplifier la figure 1.

Le détecteur 2 comprend un bloc 12 de mise en forme du signal électrique e(t). Ce bloc 12 permet de régler l'amplitude du signal e(t). A cet effet, il comporte notamment un amplificateur. Ici, le bloc 12 permet également d'améliorer le rapport signal/bruit du signal reçu.

Le signal mis en forme généré par le bloc 12 est restitué sur une sortie 16. Ce signal est un courant électrique noté $I_{RF}(t)$. Ce signal $I_{RF}(t)$ est représenté en fonction du temps t sur le chronogramme de la figure 2.

Dans cet exemple, ce signal $I_{RF}(t)$ oscille à une fréquence $f_t$ pendant une durée $T_m$. Avant et après la durée $T_m$, le signal $I_{RF}(t)$ oscille à d'autres fréquences qui ne sont pas comprises dans la bande de fréquences centrée sur la fréquence $f_t$. Typiquement, la fréquence $f_t$ est une radiofréquence, c'est-à-dire une fréquence comprise entre 100 MHz et 60 ou 120 GHz et, de préférence, comprise entre 700MHz et 40 GHz. Typiquement, la bande de fréquences centrée sur la fréquence $f_t$ fait plusieurs MHz de large. Par exemple, elle fait plus de 50MHz de large.

Avantageusement, quelle que soit la fréquence d'oscillations, l'amplitude du signal $I_{RF}(t)$ est sensiblement constante. Par sensiblement constante, on désigne le fait que les amplitudes des oscillations pendant deux durées $T_m$ successives quelconques sont égales à $\pm 5\%$ près et, de préférence, à $\pm 1\%$ près.

Le facteur de qualité des oscillations sur la durée $T_m$ est bon. Par facteur de qualité, on désigne ici le rapport suivant :

$$Q = f_t/\Delta f$$

où :

- Q est le facteur de qualité,
- $f_t$ est la fréquence des oscillations, et
- $\Delta f$ est la largeur à mi-hauteur de la raie centrée sur la fréquence $f_t$ dans le spectre de puissance de ces oscillations.

Un facteur de qualité est considéré comme bon si celui est supérieure à 1000 voire 10000.

La sortie 16 est directement raccordée sur une borne 20 de synchronisation d'un oscillateur radiofréquence 22. Cet oscillateur 22 produit un signal oscillant s(t) sur une électrode 24 de sortie. Ce signal oscillant est également connu sous le terme d' « onde ». L'électrode 24 est directement raccordée à l'entrée 26 d'un comparateur 28. Une sortie 29 de ce comparateur est directement raccordée à une borne 30 de restitution sur laquelle le détecteur 2 indique la présence ou l'absence d'oscillations à la fréquence $f_t$.

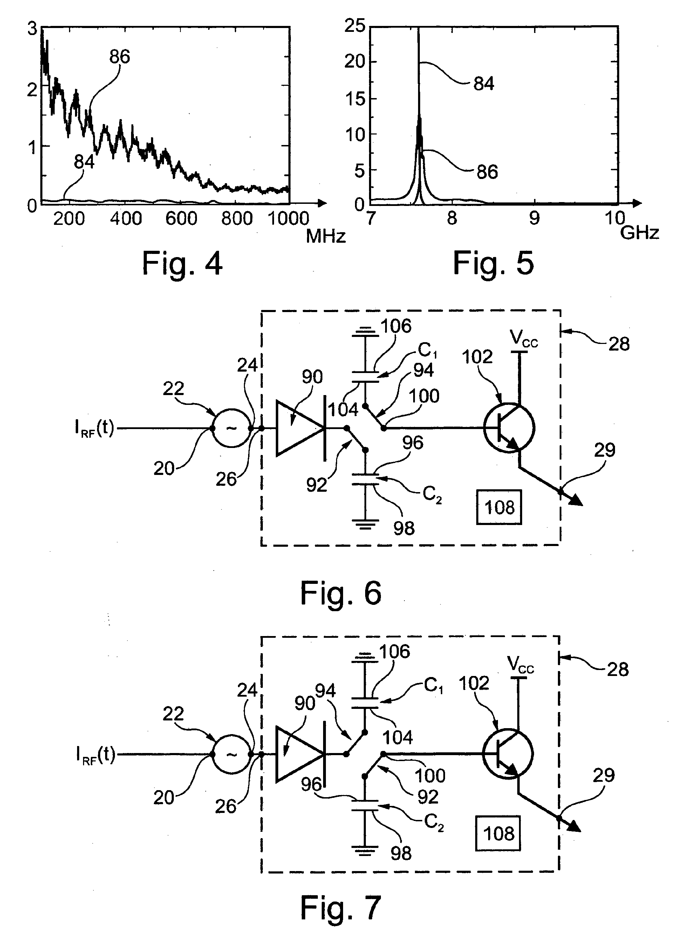

Le comparateur 28 est capable de distinguer ou de discriminer un état synchronisé d'un état non synchronisé de l'oscillateur radiofréquence 22 à partir du signal s(t). Un mode possible de réalisation de ce comparateur 28 est décrit plus en détail en référence aux figures 6 et 7.

La figure 3 représente plus en détail un exemple de réalisation de l'oscillateur 22. Cet oscillateur 22 est issu de l'électronique de spin.

L'électronique de spin utilise le spin des électrons comme degré de liberté supplémentaire afin de générer des effets nouveaux. La polarisation en spin d'un courant électrique résulte de l'asymétrie existant entre la diffusion des électrons de conduction de type "spin-up" (c'est-à-dire parallèle à l'aimantation locale) et de type "spin-down" (c'est-à-dire anti-parallèle à l'aimantation locale). Cette asymétrie conduit à une asymétrie de la conductivité entre les deux canaux de spin-up et down, d'où une polarisation de spin nette du courant électrique.

Cette polarisation en spin du courant est à l'origine de phénomènes magnétorésistifs dans les multicouches magnétiques tels que la magnétorésistance géante (Baibich, M., Broto, J.M., Fert, A., Nguyen Van Dau, F., Petroff, F.,

Etienne, P., Creuzet, G., Friederch, A. and Chazelas, J., " Giant magnetoresistance of (001) Fel (001) Cr magnetic superlattices ", Phys.Rev.Lett., 61 (1988) 2472), ou la magnétorésistance tunnel (Moodera, JS., Kinder, LR., Wong, TM. and Meservey, R.. "Large magnetoresistance at room temperature in ferromagnetic thin film tunnel junctions", Phys.Rev.Lett 74 , (1995) 3273- 6) .

Par ailleurs, il a également été observé qu'en faisant passer un courant polarisé en spin à travers une couche mince magnétique, on pouvait induire un renversement de son aimantation en l'absence de tout champ magnétique externe (Katine, J.A., Albert, F.J., Buhrman, R.A., Myers, E.B., and Ralph, D.C., "Current-Driven Magnetization Reversal and Spin-Wave Excitations in Co /Cu /Co Pillars ", Phys.Rev.Lett. 84, 3149 (2000)).

Le courant polarisé peut également générer des excitations magnétiques entretenues, également dénommées oscillations (Kiselev, S.I., Sankey, J.C., Krivorotov, LN., Emley, N.C., Schoelkopf, R.J., Buhrman, R.A., and Ralph, D.C., "Microwave oscillations of a nanomagnet driven by a spin-polarized current", Nature, 425, 380 (2003)). L'utilisation de l'effet de génération d'excitations magnétiques entretenues dans un dispositif magnétorésistif permet de convertir cet effet en une modulation de résistance électrique directement utilisable dans les circuits électroniques. Les demandes de brevet US 5 695 864 et EP1 860 769 décrivent divers développements mettant en oeuvre le principe physique mentionné précédemment. Ils décrivent notamment la précession de l'aimantation d'une couche magnétique traversée par un courant électrique polarisé en spin. Les principes physiques mis en oeuvre ainsi que la terminologie utilisée sont également décrits et définis dans la demande de brevet FR2 892 871.

La fréquence d'oscillations de ces oscillateurs radiofréquences est ajustée en jouant sur l'intensité du courant qui les traverse et, éventuellement en plus, sur un champ magnétique externe.

Ces oscillateurs radiofréquences étant connus, seul les éléments nécessaires à la compréhension du fonctionnement du détecteur 2 sont décrits plus en détail.

L'oscillateur 22 comprend un dispositif magnétorésistif 40. Ce dispositif 40 est formé d'un empilement de couches magnétiques et non magnétiques. Cet empilement peut former :

- une jonction tunnel également connue sous l'acronyme anglais de TMR (Tunnel Magnetoresistance), ou
- une vanne de spin également connue sous l'acronyme anglais de GMR (Giant Magnetoresistance).

Ici, le dispositif 40 est décrit dans le cas particulier où l'empilement forme une jonction tunnel. A cet effet, l'empilement comporte au moins les couches suivantes :

- une électrode d'entrée 42 sur laquelle est injecté un courant électrique continu $I_d$,
- une couche magnétique 44, dite « couche de référence », apte à polariser en spin le courant électrique injecté sur l'électrode 42 et dont l'aimantation est de direction fixe,
- une couche magnétique 46, dite « couche libre », dont l'aimantation peut osciller lorsqu'elle est traversée par le courant polarisé en spin,
- une couche 48 non magnétique, dite « espaceur » ou « spacer » en anglais, interposée entre les deux couches précédentes pour créer la jonction tunnel, et
- une électrode de sortie 50 sur laquelle est produit le signal oscillant s(t).

Pour obtenir une densité de courant élevée, la section transversale d'au moins l'une des couches de l'empilement présente typiquement un diamètre inférieure à 300nm et, de préférence, inférieure à 200 ou 100nm. Lorsque la section transversale n'est pas un disque, le terme « diamètre » doit être compris comme signifiant « diamètre hydraulique ». Typiquement, par densité de courant « élevée » on désigne une densité de courant supérieure à $10^6 A/cm^2$ ou $10^7 A/cm^2$.

Ce dispositif magnétorésistif 40 est conformé selon une géométrie connue sous l'acronyme CPP (« current perpendicular to plane »). Plus précisément, sur la figure 2, le dispositif magnétorésistif adopte une structure connue sous le terme de « nanopilier ». Dans cette structure les couches entres les électrodes 42 et 50 ont la même section horizontale.

La largeur L des différentes couches qui composent le pilier est constante. Ici, la largeur L est, typiquement, comprise entre 20 nm et 200 nm.

Les électrodes 42 et 50 permettent d'amener le courant qui traverse les différentes couches formant le dispositif magnétorésistif perpendiculairement au plan de ces couches. L'électrode 50 est raccordée à l'électrode 24 par l'intermédiaire d'un condensateur 51.

Les couches 44, 46 et 48 sont agencées et conformées de manière à permettre l'apparition des propriétés magnétoresistives, c'est-à-dire une variation de la résistance du pilier en fonction des directions d'aimantation des couches 44 et 46.

Pour améliorer la lisibilité de la figure 1, les proportions entre l'épaisseur des différentes couches n'a pas été préservée.

La couche de référence 44 est réalisée dans un matériau magnétique électriquement conducteur. Sa face supérieure est directement en contact avec l'espaceur 48. Elle présente une direction de plus facile aimantation comprise dans le plan de la couche.

La couche de référence 44 a pour fonction de polariser en spin les électrons du courant qui la traverse. Elle présente donc une épaisseur suffisante pour réaliser cette fonction.

Par exemple, la couche de référence 44 est réalisée en cobalt (Co), Nickel (Ni), Fer(Fe) ou leur alliage (CoFe, NiFe, CoFeB ...etc.). L'épaisseur de la couche de référence 44 est de l'ordre de quelques nanomètres. La couche de référence 44 peut être laminée par insertion de quelques (typiquement de 2 à 4) très fines couches de cuivre, d'argent ou d'or d'épaisseur de l'ordre de 0,2 à 0,5 nm pour réduire la longueur de diffusion de spin.

Ici, la couche de référence 44 présente une aimantation dont la direction est fixe. Par aimantation de direction fixe, on désigne le fait que la direction du moment magnétique de la couche de référence 44 est plus difficile à modifier que la direction du moment magnétique de la couche libre 46. Pour obtenir cela, ici, l'aimantation de la couche de référence 44 est piégée par une couche antiferromagnétique conductrice 52 interposée entre la couche de référence 44 et l'électrode 42. La face supérieure de la couche 52 est directement en contact avec la face inférieure de la couche de référence 44.

Typiquement, l'épaisseur de la couche 52 est comprise entre 5 et 50 nm. Elle peut être réalisée dans un alliage de manganèse tel que l'un des alliages suivants IrMn, PtMn, FeMn, ... etc. Par exemple, cette couche 52 est réalisée dans un matériau choisi dans le groupe comprenant IrMn, FeMn, PtMn, NiMn.

L'espaceur 48 est une couche non magnétique. Cet espaceur 48 est suffisamment fin pour permettre au courant polarisé en spin de passer de la couche de référence 44 à la couche libre 46 en limitant la perte de polarisation. A l'inverse, l'épaisseur de cet espaceur 48 est suffisamment grande pour assurer le découplage magnétique entre les couches 44 et 46.

L'espaceur 48 est réalisé dans un matériau isolant tel qu'un oxyde ou un nitrure d'aluminium, un oxyde de magnésium, du nitrure de tantale, du titanate de strontium ($SrTiO_3$), ... etc. Le pilier présente alors des propriétés magnétorésistives tunnel ou TMR (Tunnel Magnetoresistance) et l'espaceur 48 forme une barrière tunnel. Dans ce cas, l'épaisseur de l'espaceur 48 est typiquement comprise entre 0, 5 nm et 3 nm.

Ici, la barrière tunnel du dispositif 40 est fine pour présenter un facteur RA faible, c'est- à- dire compris entre 0.1 et 20 $\Omega\mu m^2$, et avantageusement inférieur à 10 voire à 5 $\Omega\mu m^2$. Le facteur RA d'une barrière tunnel est le produit de la résistance de la barrière tunnel avec son aire. Ici, l'aire est la superficie de la section transversale de la barrière tunnel.

Généralement, plus le facteur RA de la barrière tunnel est élevé plus la plage de variation de la résistivité de la jonction tunnel est élevé (par exemple supérieur à 10 %) et meilleure est la sensibilité de la jonction tunnel à la précession de l'aimantation dans la couche libre. Typiquement, pour des facteurs RA de cet ordre, on peut générer facilement des oscillations et il est possible d'obtenir des TMR comprise entre 20% et 150% du RA (typiquement 80% du RA pour un RA de 1 $\Omega$ $\mu m^2$), ce qui permet d'obtenir une bonne sensibilité de la jonction tunnel à la précession de l'aimantation dans la couche libre.

La couche libre 46 est une couche magnétique électriquement conductrice dont l'aimantation peut plus facilement tourner ou « précesser » que celle de la couche de référence 44.

De nombreux modes de réalisation de la couche libre sont possibles. Par exemple, des modes de réalisation possibles de cette couche libre sont décrits dans la demande de brevet déposée sous le numéro FR 0 957 888 et dans la demande de brevet publiée sous le numéro FR2 892 871.

La face inférieure de la couche 46 est directement en contact avec la face supérieure de l'espaceur 48. La face supérieure est quant à elle directement en contact avec l'électrode 50. Cette couche 46 est par exemple réalisée dans un matériau ferromagnétique tel que du cobalt, du nickel ou du fer ou dans un alliage de ces différents métaux (par exemple CoFe, CoFeB, NiFe, ... etc.).

En absence de courant polarisé en spin et de champ magnétique extérieur, la direction M du moment magnétique global de la couche 46 est orientée parallèlement au plan de cette couche. La direction M correspond alors à la direction de plus facile aimantation de la couche libre.

Typiquement, cet empilement de couches est réalisé sur la face supérieure d'un substrat non représenté ici.

Le dispositif 40 fonctionne comme un oscillateur à transfert de spin également connue sous l'acronyme anglais STO (Spin Transfer Oscillator) lorsque l'intensité du courant continu $I_d$ polarisé en spin dépasse un seuil $I_c$ connu sous le terme de « courant critique d'oscillations». Lorsque l'intensité du courant $I_d$ dépasse ce seuil $I_c$, l'aimantation de la couche libre du dispositif 40 précesse de façon entretenue. Le signal s(t) oscille alors à la fréquence libre $f_{lo}$. Typiquement, le seuil $I_c$, correspond à une densité de courant supérieure à $10^7 A/cm^2$ dans la section transversale des couches de l'empilement. Dans le cas contraire, le dispositif 40 se comporte comme un résonateur, également désigné par l'acronyme STR (Spin Transfer Resonator), et le signal oscillant généré est amorti et non pas entretenu. Toutefois, même dans ce cas, pour générer le signal oscillant amorti, la densité de courant dans la section transversale des couches de l'empilement doit être élevée.

Pour générer le courant continu $I_d$, l'oscillateur 22 comporte une source 60 de courant continu. Dans ce mode de réalisation, la source 60 génère un courant continu $I_d$ dont l'intensité est supérieure au seuil $I_c$.

Pour régler la fréquence libre $f_{lo}$ d'oscillations du signal s(t) généré par le dispositif 40, ici, l'oscillateur 22 est également équipé d'un générateur 70 d'un champ magnétique continu $H_b$. Ce générateur 70 est agencé par rapport au dispositif 40 de manière à ce que les lignes du champ magnétique $H_b$ traversent la couche libre 46. Par exemple, ce générateur 70 se présente sous la forme d'une piste conductrice 72 alimentée en courant continu $I_{cm}$ par une source de courant 78. La piste 72 est placée à proximité de l'empilement des couches du dispositif 40. Par exemple, cette piste 72 est agencée par rapport à la couche 46 de manière à ce que les lignes de champ magnétique générées soient parallèles à la direction M de plus facile aimantation de la couche 46. De préférence, pour limiter la consommation électrique du générateur 70, la distance la plus courte qui sépare cette piste conductrice 72 de la couche libre 46 est inférieure à 100 μm et, avantageusement, inférieure à 10μm voire à 1 μm. Sur la figure 3, la résistivité de cette piste 72 est représentée par une résistance 74. Par exemple, la valeur de résistance 74 est égale à 10 Ω et correspond à la résistance de la piste conductrice 72 entre la sortie de la source 78 et un potentiel de référence tel que la masse.

Ce générateur 70 comporte un sommateur 80 dont une entrée est directement raccordée à la borne 20 de synchronisation et l'autre entrée est directement raccordée à la sortie de la source 78 du courant continu $I_{cm}$. La sortie de ce sommateur 80 est directement raccordée à la piste 72. Ceci permet de générer, en plus du champ magnétique $H_b$, un champ magnétique alternatif $H_a$ dont la fréquence est égale à celle du signal $I_{RF}(t)$.

La fréquence d'oscillations de l'oscillateur 22 est notée $f_o$. En absence de signal sur la borne 20, cette fréquence $f_o$ est égale à la fréquence libre $f_{lo}$ d'oscillations de l'oscillateur 22. La fréquence libre est fonction du champ $H_b$ et de l'intensité du courant $I_d$. Lorsqu'un signal oscillant est reçu sur la borne 20, l'oscillateur 22 peut se synchroniser sur ce signal oscillant. Lorsque l'oscillateur 22 est synchronisé, celui-ci produit un signal oscillant s(t) qui oscille en phase avec le signal reçu sur la borne 20. De plus, lorsqu'il est synchronisé, la fréquence $f_o$ du signal s(t) produit sur l'électrode 50 devient égale à $\alpha f_t$, où :

- $f_t$ est la fréquence du signal reçu sur la borne 20, et
- $\alpha$ est un nombre rationnel s'écrivant sous la forme d'une fraction M/P, où M et P sont des entiers positifs non nuls.

M peut être un entier naturel plus grand que P ou plus petit. M et P peuvent aussi être égaux. P peut être égal à un.

A ce stade, on notera que toutes les valeurs de $\alpha$ ne sont pas possibles. En réalité, seules certaines valeurs particulières de $\alpha$ sont possibles. A ce sujet, on pourra se référer à l'article suivant :

Sergei Urazhdin et Phillip Tabor, « Franctional synchronization of spin-torque nano-oscillators », Physical review letters, PRL 105, 104101, 3 septembre 2010.

Les valeurs de $\alpha$ possibles sont par exemple déterminées expérimentalement en faisant varier la fréquence libre $f_{lo}$ et en injectant sur la borne 20 un signal de fréquence constamment égale à la fréquence $f_t$. Pour modifier la fréquence libre $f_{lo}$, il est possible de modifier l'intensité du champ magnétique $H_b$ et/ou l'intensité du courant $I_d$. Cela revient donc ici à modifier l'intensité du courant $I_d$ et/ou l'intensité du courant $I_{cm}$. En effet, il est connu que la fréquence libre $f_{lo}$ dépend de l'intensité du champ magnétique $H_b$ qui traverse la couche libre et de l'intensité du courant continu $I_d$. Par exemple, il est possible d'estimer la fréquence libre $f_{lo}$ à l'aide de la relation suivante :

$$\omega(H_b, I_d) = \omega_o(H_b) + Np(I_d) \qquad (1),$$

où :

- $\omega(H_b, I_d)$ est la pulsation de la fréquence libre $f_{lo}$, c'est-à-dire $2\Pi f_{lo}$.
- $\omega_o(H_b)$ est la pulsation de l'oscillateur 22 causée par le champ magnétique $H_b$,
- N est une constante déterminable expérimentalement, et
- $p(I_d)$ est l'amplitude des oscillations du signal s(t) en fonction de l'intensité du courant $I_d$.

La pulsation $\omega_o(H_b)$ peut être donnée par une loi de Kittel. Par exemple, lorsque le champ magnétique $H_b$ généré par le générateur 70 est parallèle à l'axe de plus facile aimantation de la couche libre 46, alors la pulsation $\omega_o(H_b)$ est donnée par la relation suivante :

$$\omega_o(H_b) = (\gamma_o/2\pi)(H_b(H_b + 4\pi M_s))^{1/2} \quad (2),$$

où :

- $\gamma_o$ est environ égal à 2,82 MHz/Oe,
- $\pi$ est le nombre "pi" radians, et
- $4\pi M_s$ est la magnétisation à saturation (environ 16.000 Oe pour une couche en CoFeB).

L'unité « Oe » est un Oersted (= $10^3/(4\pi)$ A/m soit environ 80 A/m).

Par exemple en faisant varier l'intensité du champ $H_b$ de 1 Oe à 5 kOe, cela fait varier la fréquence libre $f_{lo}$ de 356 MHz à 29 GHz. De préférence, on fait ici varier le champ $H_b$ de 50 Oe à 1,2 kOe, ce qui correspond à une variation de la fréquence libre $f_{lo}$ de 2 GHz à 13 GHz. Dans le cas du générateur 70, l'intensité du champ magnétique $H_b$ est modifiée en faisant varier l'intensité du courant $I_{cm}$.

Dans la relation (1), N est une constante en Hertz qui est propre au dispositif magnétorésistif 40. Elle est déterminable expérimentalement. Par exemple, l'évolution de la fréquence libre $f_{lo}$ en fonction de l'intensité du courant $I_d$ pour des oscillations de l'aimantation de la couche libre dans son plan, est mesurée. A partir de ces mesures, la constante N peut être calculée. Typiquement, celle-ci est de l'ordre de quelques GHz. Par exemple, ici $N/2\pi$ = 7,5 GHz.

Si les oscillations de l'aimantation de la couche libre ne sont pas comprises dans son plan, la constante $N/2\pi$ est typiquement supérieure à 20 GHz.

Plus d'explications sur les relations reliant la fréquence libre $f_{lo}$ aux différents paramètres du dispositif magnétorésistif peuvent être trouvées dans l'article suivant :

A. Slavin et V. Tiberkevich, « Nonlinear auto- oscillator theory of microwave generation by spin- polarized current » IEEE Transaction on magnetics, vol n°45, pp. 1875- 1918 (2009) .

Lorsque l'oscillateur 22 est synchronisé, le bruit basse fréquence c'est-à-dire la puissance des oscillations de fréquences inférieures à 1 GHz et, de préférence, inférieure à 100 Hz est très petite. Par très petite, on indique ici le fait que la puissance du bruit basse fréquence est au moins dix fois et, de préférence, trente fois inférieure à la puissance du bruit basse fréquence mesurable en absence de synchronisation, c'est-à-dire lorsqu'aucun signal n'est reçu sur la borne 20.

De plus, lorsque l'oscillateur 22 est synchronisé alors le facteur de qualité de l'oscillateur 22 est meilleur qu'en absence de synchronisation. Typiquement, le facteur de qualité de l'oscillateur 22 est cent fois ou mille fois voire $10^6$ fois supérieur, lorsqu'il est synchronisé, à son facteur de qualité lorsqu'aucun signal n'est reçu par l'intermédiaire de la borne 20.

Ces phénomènes sont illustrés sur les graphes des figures 4 et 5. Ces graphes ont été obtenus par simulation dans le cas particulier où la fréquence libre de l'oscillateur 22 est de 7,6 GHz.

Les graphes des figures 4 et 5 représentent des parties respectives du spectre de puissance du signal s(t) dans le cas où le signal $I_{RF}(t)$ comprends des oscillations de fréquence 15,2 GHz (courbe 84) puis des oscillations de fréquence 15,7 GHz (courbe 86). L'oscillateur 22 se synchronise sur les oscillations de 15,2 GHz car elles sont égales au double de sa fréquence libre. Par contre, il ne se synchronise pas sur les oscillations de 15,7 GHz.

Le graphe de la figure 4 représente le spectre de puissance pour des fréquences inférieures à 1 GHz. Comme illustré par ce graphe, la puissance du bruit  basse fréquence est négligeable lorsque l'oscillateur 22 est synchronisé devant la puissance de ce même bruit basse fréquence en absence de synchronisation de l'oscillateur.

Le graphe de la figure 5 représente le spectre de puissance pour des fréquences comprises entre 7 et 10 GHz. Qu'il soit synchronisé ou pas, l'oscillateur 22 oscille toujours autours de sa fréquence libre. Toutefois, comme illustré sur ce graphe, le facteur de qualité de l'oscillateur 22 est bien meilleur lorsqu'il est synchronisé que lorsqu'il ne l'est pas.

Les informations ci-dessus permettent donc de déterminer plusieurs valeurs de $\alpha$ possibles. Dans la suite de la description, les valeurs de $\alpha$ sont uniquement celles pour lesquelles une synchronisation est possible. On notera aussi que la valeur $\alpha$ =1 est toujours possible. Ainsi, si l'on souhaite uniquement que l'oscillateur 22 synchronisé oscille à la fréquence $f_t$, alors il n'est pas nécessaire de procéder à la détermination de différentes valeurs possibles pour $\alpha$.

Ici, les conditions de fonctionnement de l'oscillateur 22 sont réglées pour qu'il soit capable de se synchroniser sur des oscillations de fréquence $f_t$ dans le signal $I_{RF(t)}$. Les conditions de fonctionnement sont définies comme étant les valeurs de l'intensité du courant $I_d$ et du champ $H_b$.

Dans ce mode de réalisation, on souhaite que lorsque l'oscillateur 22 est synchronisé sur la fréquence $f_t$, il oscille à la fréquence $\alpha f_t$. A titre d'illustration, $\alpha$ est égal à ½; ¾; 1; 3/2; 5/2; 2; 3; 4 ou 7/2 ou choisi dans le groupe composé de ½ ; ¾; 3/2 ; 5/2 ; 2 ; 3 ; 4 et 7/2. Ici, $\alpha$ est choisi égal à un ou strictement inférieur à un, par exemple inférieur à 0,8. Pour cela, le courant $I_d$ et le champ $H_b$ sont réglés pour que la fréquence libre $f_{lo}$ d'oscillations soit proche de la fréquence $\alpha f_t$. A cet effet, ici, les intensités des courants $I_d$ et $I_{cm}$ sont réglées pour que la fréquence libre $f_{lo}$ soit égale à $\alpha f_t$. Le réglage se fait par exemple :

- en fixant l'intensité du courant $I_d$ juste au-dessus du seuil $I_c$, puis
- en déterminant à l'aide de la relation (2), le champ magnétique $H_b$ qui permet d'obtenir une fréquence libre d'oscillations égale à $\alpha f_t$, et enfin
- en déterminant l'intensité du courant $I_{cm}$ qui permet d'obtenir ce champ $H_b$ dans la couche libre 46.

La synchronisation se produit pour des oscillations sur la borne 20 à la fréquence $f_t$ mais également pour des oscillations sur la borne 20 à des fréquences proches de la fréquence $f_t$. Autrement dit, l'oscillateur 22 se synchronise sur toutes oscillations dont la fréquence appartient à une bande de fréquences $[f_t - \delta_t; f_t + \delta_t]$. Dans le cas présent, la largeur $2\delta_t$ de cette bande doit être suffisamment petite pour permettre à l'oscillateur 22 de se synchroniser uniquement sur des oscillations proche de la fréquence $f_t$ et non pas sur des oscillations de fréquences éloignées $f_p$ que l'on ne souhaite pas détecter. Par exemple, l'écart entre les fréquences $f_t$ et $f_p$ est d'au moins 100kHz et, de préférence, d'au moins 100MHz. La largeur de cette bande croît lorsque l'intensité du signal électrique $I_{RF}(t)$ croît. Par conséquent, ici, l'amplificateur du bloc 12 est ajusté pour que l'écart $\delta_t$ soit suffisamment petit pour que la fréquence $f_p$ n'appartienne pas à la bande $[f_t - \delta_t; f_t + \delta_t]$. Par exemple, l'intensité du signal $I_{RF}(t)$ est amplifiée jusqu'à ce que cette intensité corresponde à un champ magnétique $H_a$ à l'intérieur de la couche libre 46 au moins supérieur à 1 Oe et, de préférence, supérieur à 10 Oe. Toutefois, l'intensité du signal $I_{RF}(t)$ est maintenue suffisamment petite pour maintenir la fréquence $f_p$ en dehors de la bande $[f_t - \delta_t; f_t + \delta_t]$.

Les figures 6 et 7 représentent plus en détail un mode de réalisation particulier du comparateur 28.

Le comparateur 28 comprend une diode 90 dont l'anode est directement raccordée à la borne 26. La cathode de la diode 90 est raccordée à un jeu de deux interrupteurs 92 et 94 commandables.

L'interrupteur 92 est raccordé en permanence à une électrode 96 d'un condensateur $C_2$. L'autre électrode 98 de ce condensateur $C_2$ est raccordée à la masse. L'interrupteur 92 raccorde la cathode de la diode 90 à l'électrode 96 (figure 6) et, en alternance, l'électrode 96 à une borne 100 de commande d'un dispositif 102 d'indication de la charge d'un condensateur (figure 7).

L'interrupteur 94 est raccordé en permanence à une électrode 104 d'un condensateur $C_1$. L'autre électrode 106 de ce condensateur $C_1$ est raccordée à la masse. L'interrupteur 94 raccorde la cathode de la diode 90 à l'électrode 104 (figure 7) et, en alternance, l'électrode 104 à la borne de commande 100 (figure 6).

Ici, le dispositif 102 est un transistor dont la base forme l'électrode de commande 100. Le collecteur de ce transistor est raccordé en permanence à une source de tension continue $V_{cc}$. L'émetteur de ce transistor est directement raccordé à la borne 29.

Le comparateur 28 comporte également une horloge 108 apte à commander les interrupteurs 92 et 94 pour qu'ils basculent en alternance et à intervalle régulier entre l'état représenté sur la figure 6 et l'état représenté sur la figure 7.

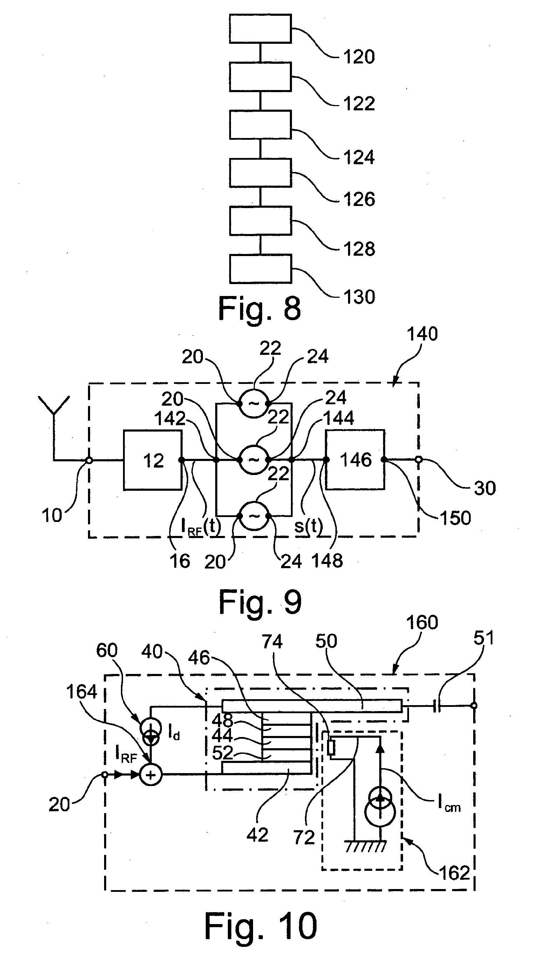

Le fonctionnement du détecteur 2 va maintenant être décrit plus en détail en regard du procédé de la figure 8.

Initialement, lors d'une étape 120, l'intensité des courants $I_d$ et $I_{cm}$ sont réglées pour que la fréquence libre $f_{lo}$ soit égale à $\alpha f_t$. De plus, l'intensité du courant $I_d$ est choisie supérieure ou égale à l'intensité du courant critique $I_c$ de manière à ce que le dispositif magnétorésistif 40 oscille.

Lors d'une étape 122, le bloc 12 de mise en forme du signal $I_{RF}(t)$ est réglé pour que l'écart $\delta_t$ soit suffisamment petit de manière à ce que la ou les fréquences $f_p$ que l'on ne souhaite pas détecter n'appartiennent pas à la bande $[f_t - \delta_t; f_t + \delta_t]$.

A partir de ce moment, le détecteur 2 peut être utilisé pour détecter des oscillations à l'intérieur de la bande $[f_t - \delta_t; f_t + \delta_t]$.

Plus précisément, lors d'une étape 124, l'horloge 108 commande en permanence le basculement des interrupteurs 92 et 94 entre les états représentés, respectivement, sur les figures 6 et 7. La fréquence de basculement entre les états des figures 6 et 7 est notée $f_m$. De préférence, cette fréquence $f_m$ est choisie strictement inférieure à une fréquence $\Gamma_c$. La fréquence $\Gamma_c$ est le taux de relaxation d'amplitude du dispositif magnétorésistif 40. Cette fréquence $\Gamma_c$ représente le fait que l'oscillateur 22 ne se synchronise pas instantanément sur la fréquence $f_t$. Autrement dit, l'oscillation comprise dans la bande $[f_t - \delta_t; f_t + \delta_t]$ doit être présente dans le signal $e(t)$ pendant une durée au moins supérieure à $1/\Gamma_c$ pour que l'oscillateur 22 ait le temps de se synchroniser sur cette oscillation. Il a été mesuré expérimentalement que la fréquence $\Gamma_c$ est comprise entre 50 MHz et 50 GHz et typiquement comprise entre 100 MHz et 10 GHz. Ainsi, le débit maximum d'informations est compris entre 50 Mbit/s et 10 ou 50 Gbit/s.

La fréquence $f_m$ est également choisie suffisamment grande pour détecter rapidement la synchronisation de l'oscillateur 22. Par exemple, la fréquence $f_m$ est choisie plus grande que l'inverse de la plus petite durée $T_m$ des oscillations de la bande $[f_t - \delta_t; f_t + \delta_t]$ que l'on souhaite détecter.

Lors d'une étape 126, le signal $e(t)$ est reçu sur la borne 10 d'acquisition. Son amplitude est alors ajustée par le bloc 12 pour produire le signal $I_{RF}(t)$ qui est injecté sur la borne 20 de synchronisation de l'oscillateur 22.

Lors d'une étape 128, si des oscillations à une fréquence comprise dans la bande $[f_t - \delta_t; f_t + \delta_t]$ sont présentes dans le signal $I_{RF}(t)$ injecté sur la borne 20, alors, l'oscillateur 22 se synchronise. Dans le cas contraire, l'oscillateur 22 ne se synchronise pas.

Lors d'une étape 130, le comparateur 28 reçoit le signal oscillant s(t) produit par l'oscillateur 22 sur sa borne 26. A partir de ce signal oscillant s(t), il discrimine un état synchronisé d'un état non synchronisé de l'oscillateur 22. Il indique aussi la présence d'oscillations de fréquence $f_t$ uniquement si un état synchronisé de l'oscillateur 22 est identifié.

Plus précisément, si l'oscillateur 22 est synchronisé sur la fréquence $f_t$, dans l'état de la figure 6, le condensateur $C_2$ ne se charge pas ou que très lentement puisque la puissance du bruit basse fréquence est négligeable. Ensuite, l'horloge 108 fait basculer les interrupteurs 92 et 94 de l'état représenté sur la figure 6 vers l'état représenté sur la figure 7. Etant donné que le condensateur $C_2$ ne s'est pas chargé, lorsque celui-ci est raccordé à la borne de commande 100, il ne peut pas commander la fermeture du transistor 102. Le potentiel sur la sortie 29 est donc flottant, ce qui indique la présence d'oscillations à la fréquence $f_t$ pendant la période précédente.

A l'inverse, si l'oscillateur 22 n'est pas synchronisé, dans l'état représenté sur la figure 6, le condensateur $C_2$ est rapidement chargé par le bruit basse fréquence. Ensuite, lorsque l'horloge 108 fait basculer les interrupteurs 92 et 94 dans l'état de la figure 7, le condensateur $C_2$ se décharge dans la borne de commande 100. Ceci provoque la fermeture du transistor 102. Par conséquent, la sortie 29 est au potentiel $V_{cc}$ lorsque aucune oscillation de fréquence $f_t$ n'a été détectée pendant la période précédente de l'horloge 108.

Le fonctionnement du condensateur $C_1$ et de l'interrupteur 94 se déduit de ce qui a été décrit précédemment pour l'interrupteur 92 et le condensateur $C_2$. Ainsi, dans ce mode particulier de réalisation du comparateur 28, la présence d'oscillations de fréquence $f_t$ se traduit sur la borne 29 par la présence d'un potentiel flottant. A l'inverse, l'absence d'oscillations de fréquence $f_t$ dans le signal e(t) se traduit par la présence d'une tension $V_{cc}$ sur les bornes 29 et 30.

La figure 9 représente un détecteur 140 d'oscillations à l'intérieure de la bande $[f_t - \delta_t; f_t + \delta_t]$. Ce détecteur 140 est identique au détecteur 2 à l'exception du fait que :

- l'oscillateur 22 est remplacé par plusieurs oscillateurs 22 raccordés en parallèle entre une borne commune 142 de synchronisation et une électrode commune 144 de sortie, et
- le comparateur 28 est remplacé par un comparateur 146.

Pour simplifier la figure 9, seuls trois oscillateurs raccordés en parallèle sont représentés. Les bornes 20 de synchronisation de chacun de ces oscillateurs 22 sont raccordées à la borne commune 142 qui est elle-même directement raccordée à la sortie 16 du bloc 12. Les électrodes de sortie 24 de chacun des oscillateurs 22 raccordés en parallèle sont raccordées à l'électrode commune 144 de sortie qui est elle-même raccordée directement à une borne 148 d'entrée du comparateur 146. Une borne de sortie 150 de ce comparateur 146 est directement raccordée à la borne 30 de restitution.

Les oscillateurs 22 raccordés en parallèle sont tous configurés pour se synchroniser sur des oscillations dans la même bande de fréquences $[f_t - \delta_t; f_t + \delta_t]$. De plus, lorsqu'ils sont synchronisés, ils oscillent tous à la même fréquence $\alpha f_t$.

Les signaux oscillants produits par chacun des oscillateurs 22 se superposent sur l'électrode 144. Lorsque les oscillateurs 22 sont synchronisés sur une oscillation dont la fréquence est comprise dans la bande $[f_t - \delta_t; f_t + \delta_t]$, ils oscillent en phase. Dès lors, la puissance du signal s (t) produit sur la borne 144 est donnée par la relation suivante : $P_t = K^2 P \cos(f_t)$, où :

- $P_t$ est la puissance totale du signal s(t) à la fréquence $f_t$ produit sur l'électrode 144,
- K est le nombre d'oscillateurs 22 raccordés en parallèle, et
- P est la puissance du signal produit par chacun de ces oscillateurs 22 à la fréquence $f_t$.

De plus, les bruits basses fréquences des oscillateurs 22 ne sont généralement pas corrélés. Ainsi, la superposition des signaux des oscillateurs 22 n'augmente pas le bruit basse fréquence. Le rapport signal-sur-bruit est donc amélioré.

A l'inverse, en absence d'oscillation dans la bande $[f_t - \delta_t; f_t + \delta_t]$ dans le signal $I_{RF}(t)$, les oscillateurs 22 ne sont pas synchronisés et oscillent chacun à leur fréquence libre $f_{lo}$. Dans ces conditions, les oscillateurs 22 raccordés en parallèle n'oscillent pas en phase. La puissance des signaux oscillants produits par chacun des oscillateurs 22 ne s'additionne pas au niveau de l'électrode 144. Ainsi, en absence de synchronisation sur des oscillations de fréquence $f_t$, la puissance du signal s(t), à la fréquence $f_t$, est très nettement inférieure à celle qui peut être observée lorsque les oscillateurs 22 sont synchronisés sur les mêmes oscillations. Par « très nettement inférieure », on indique ici que la puissance à la fréquence $f_t$ du signal s(t) lorsque les oscillateurs 22 sont synchronisés est au moins K fois supérieure à la puissance de ce signal s(t) à la fréquence $f_t$ lorsque les oscillateurs 22 ne sont pas synchronisés.

Le comparateur 146, comme le comparateur 28, discrimine l'état synchronisé de l'état non synchronisé des oscillateurs 22. A cet effet, il utilise le signal s(t) produit sur la borne 144. Par exemple, dans un premier mode de réalisation, le comparateur 146 compare l'enveloppe du spectre de puissance autour de la fréquence $f_t$ du signal s(t) à un gabarit prédéterminé. Si l'enveloppe est dans ce gabarit prédéterminé, alors cela signifie que les oscillateurs 22 sont synchronisés et le comparateur 146 indique en réponse sur la borne 150, la présence d'oscillations dans la bande $[f_t -$

$\delta_t$ ; $f_t + \delta_t$] dans le signal e(t). Dans le cas contraire, si l'enveloppe du signal s(t) autour de la fréquence $f_t$ ne rentre pas dans le gabarit prédéterminé, cela signifie que les oscillateurs 22 ne sont pas dans leurs états synchronisés et, en réponse, le comparateur 146 indique sur la sortie 150 l'absence d'oscillations dans la bande [$f_t$ - $\delta_t$; $f_t$ + $\delta_t$].

Dans un autre mode de réalisation, le comparateur 146 compare la puissance du signal s(t) à un seuil prédéterminé $S_1$ de puissance. Lorsque les oscillateurs 22 sont synchronisés, la puissance du signal s(t) dépasse ce seuil $S_1$. En réponse, le comparateur 146 indique sur sa sortie 150 la présence d'oscillations dans la bande [$f_t$ - $\delta_t$; $f_t$ + $\delta_t$]dans le signal e(t).

Dans le cas contraire, si le seuil $S_1$ n'est pas franchi, le comparateur 146 indique sur la sortie 150, l'absence d'oscillation dans la bande [$f_t$ - $\delta_t$; $f_t$ + $\delta_t$].

La figure 10 représente un oscillateur 160 susceptible d'être utilisé en lieu et place de l'oscillateur 22. Cet oscillateur 160 est identique à l'oscillateur 22 sauf que le générateur 70 est remplacé par un générateur 162 et le générateur 60 est raccordé à l'électrode d'entrée 42 par l'intermédiaire d'un sommateur 164.

Le générateur 162 est identique au générateur 70 sauf que le sommateur 80 est omis. Ainsi, dans ce mode de réalisation, la synchronisation avec le signal $I_{RF}(t)$ ne se fait pas par l'intermédiaire d'un champ magnétique alternatif. Dans ce mode de réalisation, le champ magnétique $H_b$ est constant.

Le sommateur 164 possède une entrée directement raccordée à la sortie du générateur 60 de courant continu et une autre entrée directement raccordée à la borne 20 de synchronisation. Une sortie de ce sommateur 164 est directement raccordée à l'électrode 42. Par conséquent, ce sommateur 164 ajoute le signal $I_{RF}(t)$ au courant continu $I_d$. Ainsi, lorsque l'oscillateur 160 est utilisé à la place de l'oscillateur 22, la synchronisation de la fréquence de l'oscillateur sur la fréquence $f_t$ se fait en injectant le signal électrique $I_{RF}(t)$ sur l'électrode 42.

Le fonctionnement du détecteur 2 lorsqu'il est équipé de l'oscillateur 160 se déduit des explications qui ont été précédemment données dans le cas de l'oscillateur 22. En particulier, pour que la synchronisation de l'oscillateur 160 sur la fréquence $f_t$ se produise, il faut régler les intensités des courants $I_d$ et $I_{cm}$ comme décrit précédemment. Il faut également que l'intensité du courant $I_{RF}(t)$ ne soit pas négligeable devant l'intensité du courant $I_d$. Pour cela, le bloc 12 est réglé pour que l'intensité du courant $I_{RF}(t)$ soit au moins supérieure à 10% de l'intensité du courant $I_d$. L'intensité du courant $I_{RF}(t)$ est également choisie suffisamment petite pour que la ou les fréquences $f_p$ sur lesquelles on ne souhaite pas se synchroniser soient en dehors de la bande [$f_t$ - $\delta_t$; $f_t$ + $\delta_t$].

De nombreuses autres modes de réalisation sont possibles. Par exemple, le générateur du champ magnétique $H_b$ peut être distinct de celui qui génère le champ $H_a$.

Il n'est pas nécessaire que la fréquence libre $f_{lo}$ soit strictement égale à $\alpha f_t$. En variante, les intensités des courants $I_{cm}$ et $I_d$ sont réglées de manière à ce que la fréquence $f_{lo}$ soit égale à la fréquence $\alpha f_t$ à plus ou moins 60% ou 45% ou 30 % près et, de préférence, à plus ou moins 10 ou 5% près.

En variante, $\alpha$ est différent de un ou strictement supérieur à un ou 1,2. Par exemple, il est choisi dans le groupe composé de 2 ; 3/2 ; 5/2 et 3. $\alpha$ égal à 2 est un mode de réalisation qui marche particulièrement bien.

De nombreux autres modes de réalisation du dispositif magnétorésistif 40 sont possibles. Par exemple, la direction de plus facile aimantation de la couche libre et/ou de la couche de référence n'est pas forcément contenue dans le plan de la couche. Par exemple, la direction de plus facile aimantation peut être perpendiculaire au plan de la couche.

Il est possible également que la couche 44 soit un multicouche, par exemple, un SyF (Synthetic Ferrimagnetic) voire un SAF (Synthetic AntiFerromagnetic). Cela permet de piéger la direction d'aimantation de la cette couche sans qu'il soit nécessaire d'utiliser une couche antiferromagnétique complémentaire pour cela. La couche 52 peut donc être omise dans ce cas.

L'espaceur 48 peut être réalisé dans un matériau électriquement conducteur tel que le cuivre (Cu). Les propriétés magnétorésistives du pilier sont alors qualifiées de magnétorésistance géante ou GMR (Giant Magneto Resistance).

Un (ou plusieurs) polariseur peut aussi être utilisé pour réaliser le dispositif magnétorésistif en plus de la couche de référence. Un polariseur est une couche ou un multicouche magnétique dont l'aimantation est en dehors du plan de la couche et, par exemple, perpendiculaire au plan de la couche. Le polariseur permet de polariser en spin le courant qui le traverse. Typiquement, le polariseur est composé de plusieurs sous-couches superposées les unes sur les autres, par exemple une alternance de couches magnétiques et métalliques (par exemple $(Co/Pt)_n$). Ici, le polariseur n'est pas décrit plus en détail. Pour plus d'informations sur les polariseurs, il est possible de se référer à la demande de brevet FR2 817 998. La présence du polariseur permet d'obtenir une précession de l'aimantation de la couche libre en dehors de son plan. Cela permet par exemple de faire fonctionner l'oscillateur en champ nul, c'est-à-dire en absence de champ magnétique extérieur statique. Par exemple, un polariseur est directement déposé sur l'électrode 42. Ainsi, dans le mode de réalisation de la figure 8, le générateur 122 de champ magnétique peut être omis, par exemple, si un polariseur est utilisé.

Le générateur 70 de champ magnétique peut être réalisé différemment. Par exemple, le champ magnétique $H_b$ peut être généré par une couche aimantée située à proximité de la couche libre.

Le champ magnétique $H_b$ peut être parallèle ou perpendiculaire à la direction de plus facile aimantation de la couche libre. Il peut aussi former un angle quelconque avec cette direction de plus facile aimantation. Le choix de cet angle modifie les valeurs du coefficient $\alpha$ possibles.

D'autre mode de réalisation du comparateur 28 ou 146 sont possibles. En particulier, les comparateurs 28 et 146 peuvent être utilisés l'un à la place de l'autre.

En dehors des durées $T_m$ où le signal e(t) oscille à une fréquence comprise dans la bande $[f_t-\delta_t; f_t+\delta_t]$, le signal e(t) est telle qu'il ne permet pas la synchronisation de l'oscillateur radiofréquence. Par exemple, en dehors des durées $T_m$, le signal e(t) peut ne pas osciller où présenter une forme d'onde différente d'une oscillation à une fréquence pure.

D'autre mode de réalisation du comparateur sont également possible. Par exemple, le comparateur peut utiliser l'écart entre les phases des signaux $I_{RF}(t)$ et s(t) pour déterminer si l'oscillateur radiofréquence est dans l'état synchronisé ou non.

**Revendications**

1. Détecteur d'oscillations, dans une bande de fréquences autour d'une fréquence $f_t$, dans un signal électrique radiofréquence e(t) reçu, ce détecteur comportant :

  - une borne (10) d'acquisition sur laquelle est reçu le signal e(t), et
  - un oscillateur radiofréquence (22 ; 160) comportant :

    • au moins un dispositif magnétorésistif (40) au sein duquel circule un courant électrique polarisé en spin pour générer un signal oscillant sur une électrode de sortie (24), ce dispositif étant formé d'un empilement de couches magnétiques et non magnétiques,

  **caractérisé en ce que** :

  - l'oscillateur radiofréquence, configuré pour se synchroniser sur la fréquence $f_t$, com porte :

    • une borne (20) de synchronisation de la fréquence du signal oscillant sur la fréquence du signal reçu sur cette borne, cette borne étant raccordée à la borne d'acquisition, et
    • une source (60) de courant pour faire circuler un courant continu d'électrons dans lesdites couches perpendiculairement à celles-ci, et/ou un générateur (70) de champ magnétique continu, le courant continu d'électrons et/ou le champ magnétique continu étant réglés de manière à ce que la fréquence libre $f_{lo}$ d'oscillations du signal oscillant produit en absence de signal sur la borne de synchronisation soit égale à la fréquence $\alpha f_t$ à $\pm 60\%$ près, où $\alpha$ est un nombre rationnel positif,

  - un comparateur électronique (28 ; 146) apte :

    • à discriminer automatiquement l'état synchronisé de l'état non synchronisé de l'oscillateur radiofréquence à partir du signal oscillant produit par cet oscillateur radiofréquence, l'état synchronisé étant un état dans lequel la puissance de composantes basses fréquences du signal oscillant produit par l'oscillateur radiofréquence est inférieur à un seuil prédéterminé de puissance, et l'état non synchronisé étant un état dans lequel la puissance de ces composantes basses fréquences du signal oscillant produit par l'oscillateur radiofréquence est supérieur à ce seuil prédéterminé de puissance, les composantes basses fréquences ayant une fréquence inférieure à 1 GHz, et
    • à indiquer la présence d'oscillations, dans la bande de fréquences autour de la fréquence $f_t$, dans le signal e(t) en réponse à l'état synchronisé et, en alternance, à indiquer l'absence d'oscillation dans cette bande de fréquences dans le signal e(t) dans le cas contraire.

2. Détecteur selon la revendication 1, dans lequel le comparateur (28) est configuré :

  - pour comparer la puissance de composantes basses fréquences du signal oscillant produit par l'oscillateur radiofréquence à un seuil prédéterminé de puissance, les composantes basses fréquences ayant une fréquence inférieure à 1 GHz, et
  - pour indiquer la présence d'oscillations dans la bande de fréquences autour de la fréquence $f_t$ dans le signal e(t) si la puissance des composantes basses fréquences est inférieure à ce seuil prédéterminé et, dans le cas contraire, à indiquer l'absence de telles oscillations dans le signal e(t).

**3.** Détecteur selon la revendication 2, dans lequel le comparateur comporte :

- au moins un premier condensateur ($C_1$, $C_2$),
- au moins un interrupteur (92, 94) commandable basculable entre :

• un état de charge dans lequel l'électrode de sortie (24 ; 144) dudit au moins un oscillateur radiofréquence est électriquement raccordée au condensateur, et
• un état de lecture dans lequel le condensateur ($C_1$, $C_2$) est raccordé à un dispositif d'indication de sa charge et l'électrode de sortie dudit au moins un oscillateur radiofréquence est électriquement isolé de ce condensateur, et

- une horloge (108) raccordée à l'interrupteur pour commander automatiquement son basculement entre les deux états.

**4.** Détecteur selon la revendication 1, dans lequel le détecteur comprend :

- une borne commune (142) de synchronisation destinée à recevoir le signal e(t),
- une électrode commune (144) de sortie,
- plusieurs dispositifs magnétorésistifs (22) configurés chacun pour se synchroniser sur les oscillations de fréquence $f_t$, la borne (20) de synchronisation de chaque oscillateur radiofréquence étant raccordée à la borne commune (142) de synchronisation pour recevoir le même signal e(t) et l'électrode (24) de sortie de chaque oscillateur radiofréquence étant raccordée à l'électrode commune (144) de sortie pour que les signaux oscillants produits par chacun des oscillateurs radiofréquences se superposent sur l'électrode commune de sortie, et
- le comparateur (146) est apte à discriminer l'état synchronisé de l'état non synchronisé à partir du signal oscillant obtenu sur l'électrode commune de sortie.

**5.** Détecteur selon l'une quelconque des revendications précédentes, dans lequel l'empilement de couches du dispositif magnétorésistif comprend au moins les couches suivantes :

- une électrode d'entrée (42) par laquelle est injecté un courant électrique continu,
- une première couche magnétique (44), dite « couche de référence », apte à polariser en spin le courant électrique et dont l'aimantation est de direction fixe,
- une seconde couche magnétique (46), dite « couche libre », dont l'aimantation peut osciller lorsqu'elle est traversée par le courant polarisé en spin,
- une couche non magnétique (48), dite « espaceur », interposée entre les deux couches précédentes pour former une jonction tunnel ou une vanne de spin, et
- l'électrode (50) de sortie sur laquelle est produit le signal oscillant à une fréquence d'oscillation fonction de l'intensité du courant continu ou de l'amplitude d'un champ magnétique continu dont les lignes de champ traversent la couche libre,
- la section transversale d'au moins l'une des couches de cet empilement présentant un diamètre inférieur à 300 nm.

**6.** Détecteur selon la revendication 5, dans lequel l'oscillateur radiofréquence comporte un générateur (70 ; 162) de champ magnétique apte à générer un champ magnétique continu dont les lignes de champ traversent la couche libre avec une intensité supérieure ou égale à 1 Oe.

**7.** Procédé de détection d'oscillations, dans une bande de fréquences autour d'une fréquence $f_t$, dans un signal électrique radiofréquence e(t) reçu, **caractérisé en ce que** ce procédé comporte :

- la réception (126) du signal e(t) sur une borne de synchronisation d'un oscillateur radiofréquence configuré pour se synchroniser sur la fréquence $f_t$, cet oscillateur radiofréquence comportant en plus de cette borne :

• au moins un dispositif magnétorésistif au sein duquel circule un courant électrique polarisé en spin pour générer un signal oscillant sur une électrode de sortie, ce dispositif étant formé d'un empilement de couches magnétiques et non magnétiques,
• une source de courant pour faire circuler un courant continu d'électrons dans lesdites couches perpendiculairement à celles-ci et/ou un générateur (70) de champ magnétique continu, le courant continu d'électrons et/ou le champ magnétique continu étant réglés de manière à ce que la fréquence libre $f_{l_o}$ d'oscillations

du signal oscillant produit en absence de signal sur la borne de synchronisation soit égale à la fréquence $\alpha f_t$ à $\pm 60\%$ près, où $\alpha$ est un nombre rationnel positif,

- la discrimination automatique (130) de l'état synchronisé de l'état non synchronisé à partir du signal oscillant produit par cet oscillateur radiofréquence, l'état synchronisé étant un état dans lequel la puissance de composantes basses fréquences du signal oscillant produit par l'oscillateur radiofréquence est inférieur à un seuil prédéterminé de puissance, et l'état non synchronisé étant un état dans lequel la puissance de ces composantes basses fréquences du signal oscillant produit par l'oscillateur radiofréquence est supérieur à ce seuil prédéterminé de puissance, les composantes basses fréquences ayant une fréquence inférieure à 1 GHz, et
- l'indication de la présence d'oscillations dans la bande de fréquences autour de la fréquence $f_t$ dans le signal e(t) en réponse à l'état synchronisé et, en alternance, l'indication de l'absence d'oscillation dans cette bande de fréquences dans ce signal e(t) dans le cas contraire.

**8.** Procédé selon la revendication 7, dans lequel $\alpha$ est choisi dans le groupe composé de 1/2 ; 3/4 ; 1 ; 3/2 ; 5/2 ; 2 ; 3 ; 4 et 7/2.

**9.** Procédé selon la revendication 7 ou 8, dans lequel le signal e(t) est amplifié de manière à ce que l'étendue de la bande, autour de la fréquence libre $f_t$, des fréquences avec lesquels l'oscillateur radiofréquence peut se synchroniser comprenne la fréquence $f_t$.

**10.** Procédé selon l'une quelconque des revendications 7 à 9, dans lequel le signal électrique e(t) est amplifié de manière à ce que son intensité sur la borne de synchronisation soit supérieure à 10 % de l'intensité du courant continu ou corresponde à un champ magnétique alternatif supérieur à 1 Oe à l'intérieur de la couche libre lorsqu'il est transformé en champ magnétique par un générateur.

**Patentansprüche**

**1.** Detektor von Oszillationen in einem Frequenzband um eine Frequenz $f_t$, in einem empfangenen elektrischen Hochfrequenzsignal e(t), wobei dieser Detektor Folgendes aufweist:

- eine Erfassungsklemme (10), auf der das Signal e(t) empfangen wird und
- einen Hochfrequenzoszillator (22; 160), der Folgendes aufweist:

    • mindestens eine magnetoresistive Vorrichtung (40), innerhalb welcher ein spinpolarisierter elektrischer Strom zirkuliert, um ein oszillierendes Signal auf einer Ausgangselektrode (24) zu erzeugen, wobei diese Vorrichtung aus einer Stapelung magnetischer und nicht magnetischer Schichten gebildet ist,

**dadurch gekennzeichnet, dass**:

- der Hochfrequenzoszillator, der konfiguriert ist, um sich auf der Frequenz $f_t$ zu synchronisieren, Folgendes aufweist:

    • eine Klemme (20) zum Synchronisieren der Frequenz des oszillierenden Signals auf der Frequenz des auf dieser Klemme empfangenen Signals, wobei diese Klemme an die Erfassungsklemme angeschlossen ist, und
    • eine Stromquelle (60), um einen Gleichstrom von Elektronen in den senkrecht zu diesen liegenden Schichten zirkulieren zu lassen, und/oder einen Generator (70) eines magnetischen Gleichfelds, wobei der Elektronengleichstrom und/oder das magnetische Gleichfeld derart eingestellt sind, dass die von Oszillationen freie Frequenz $f_{lo}$ des erzeugten oszillierenden Signals bei Fehlen eines Signals auf der Synchronisationsklemme auf $\pm$ 60 % genau gleich der Frequenz $\alpha f_t$ ist, wobei $\alpha$ eine positive rationale Zahl ist,

- einen elektronischen Komparator (28; 146), der geeignet ist:

    • um automatisch den synchronisierten Zustand von dem nicht synchronisierten Zustand des Hochfrequenzoszillators ausgehend von dem oszillierenden Signal, das von diesem Hochfrequenzoszillator erzeugt wird, zu unterscheiden, wobei der synchronisierte Zustand ein Zustand ist, bei dem die Leistung von Niederfrequenzkomponenten des oszillierenden Signals, das von dem Hochfrequenzoszillator erzeugt wird, kleiner ist als ein vorbestimmter Leistungsschwellenwert, und der nicht synchronisierte Zustand ein Zustand ist, in dem die Leistung dieser Niederfrequenzkomponenten des oszillierenden Signals, das von dem Hochfrequenzoszillator erzeugt wird, größer ist als dieser vorbestimmte Leistungsschwellenwert, wobei die Niederfrequenzkomponenten eine Frequenz kleiner als 1 GHz haben, und

• um die Gegenwart von Oszillationen in dem Frequenzband um die Frequenz $f_t$ in dem Signal e(t) als Reaktion auf den synchronisierten Zustand anzuzeigen, und, abwechselnd, im gegenteiligen Fall, das Fehlen von Oszillationen in diesem Frequenzband in dem Signal e(t) anzuzeigen.

**2.** Detektor nach Anspruch 1, bei dem der Komparator (28) konfiguriert ist:

- um die Leistung von Niederfrequenzkomponenten des oszillierenden Signals, das von dem Hochfrequenzoszillator erzeugt wird, mit einem vorbestimmten Leistungsschwellenwert zu vergleichen, wobei die Niederfrequenzkomponenten eine Frequenz kleiner als 1 GHz haben, und
- um die Gegenwart von Oszillationen in dem Frequenzband um die Frequenz $f_t$ in dem Signal e(t) anzuzeigen, wenn die Leistung der Niederfrequenzkomponenten kleiner ist als dieser vorbestimmte Schwellenwert, und, im gegenteiligen Fall, das Fehlen solcher Oszillation in dem Signal e(t) anzuzeigen.

**3.** Detektor nach Anspruch 2, wobei der Komparator Folgendes aufweist:

- mindestens einen ersten Kondensator ($C_1$, $C_2$),
- mindestens einen steuerbaren Schalter (92, 94), der umschaltbar ist zwischen:

• einem Ladezustand, in dem die Ausgangselektrode (24; 144) des mindestens einen Hochfrequenzoszillators elektrisch mit dem Kondensator verbunden ist, und
• einem Lesezustand, in dem der Kondensator ($C_1$, $C_2$) an eine Vorrichtung zum Anzeigen seiner Ladung angeschlossen ist und die Ausgangselektrode des mindestens einen Hochfrequenzoszillators von diesem Kondensator elektrisch isoliert ist, und

- einen Taktgeber (108), der an den Schalter angeschlossen ist, um sein Umschalten zwischen den Zuständen automatisch zu steuern.

**4.** Detektor nach Anspruch 1, wobei der Detektor Folgendes aufweist:

- eine gemeinsame Synchronisationsklemme (142), die dazu bestimmt ist, das Signal e(t) zu empfangen,
- eine gemeinsame Ausgangselektrode (144),
- mehrere magnetoresistive Vorrichtungen (22), die jeweils konfiguriert sind, um sich auf den Oszillationen der Frequenz $f_t$ zu synchronisieren, wobei die Synchronisationsklemme (20) jedes Hochfrequenzoszillators an die gemeinsame Synchronisationsklemme (142) angeschlossen ist, um dasselbe Signal e(t) zu empfangen, und die Ausgangselektrode (24) jedes Hochfrequenzoszillators an die gemeinsame Ausgangselektrode (144) angeschlossen ist, damit sich die von jedem der Hochfrequenzoszillatoren erzeugten oszillierenden Signale auf der gemeinsamen Ausgangselektrode überlagern, und
- wobei der Komparator (146) angepasst ist, um den synchronisierten Zustand von dem nicht synchronisierten Zustand ausgehend von dem auf der gemeinsamen Ausgangselektrode erzielten oszillierenden Signal zu unterscheiden.

**5.** Detektor nach einem der vorhergehenden Ansprüche, bei dem die Stapelung von Schichten der magnetoresistiven Vorrichtung mindestens die folgenden Schichten aufweist

- eine Eingangselektrode (42), durch welche ein elektrischer Gleichstrom injiziert wird,
- eine erste magnetische Schicht (44), "Bezugsschicht" genannt, die geeignet ist, um den elektrischen Strom zu spinpolarisieren und deren Magnetisierung eine festgelegte Richtung hat,
- eine zweite magnetische Schicht (46), "freie Schicht" genannt, deren Magnetisierung oszillieren kann, wenn sie von dem spinpolarisierten Strom durchquert wird,
- eine nicht magnetische Schicht (48), "beabstandende Schicht" genannt, die zwischen den zwei vorhergehenden Schichten eingefügt ist, um eine Tunnelverbindung oder ein Spinventil zu bilden, und
- die Ausgangselektrode (50), auf der oszillierendes Signal mit einer Oszillationsfrequenz erzeugt wird, die von der Stärke des Gleichstroms oder der Amplitude eines magnetischen Gleichfelds, dessen Feldlinien die freie Schicht durchqueren, abhängt,

- wobei der Querschnitt mindestens einer der Schichten dieser Stapelung einen Durchmesser kleiner als 300 nm aufweist.

**6.** Detektor nach Anspruch 5, bei dem der Hochfrequenzoszillator einen Magnetfeldgenerator (70; 162) aufweist, der geeignet ist, um ein magnetisches Gleichfeld zu erzeugen, dessen Feldlinien die freie Schicht mit einer Stärke größer oder gleich 1 Oe durchqueren.

**7.** Verfahren zum Erfassen von Oszillationen in einem Frequenzband um eine Frequenz $f_t$ in einem empfangenen elektrischen Hochfrequenzsignal e(t), **dadurch gekennzeichnet, dass** dieses Verfahren Folgendes aufweist:

- den Empfang (126) des Signals e(t) auf einer Synchronisationsklemme eines Hochfrequenzoszillators, der konfiguriert ist, um sich auf der Frequenz $f_t$ dieses Hochfrequenzoszillators zu synchronisieren, der zusätzlich zu dieser Klemme Folgendes aufweist:

    • mindestens eine magnetoresistive Vorrichtung, innerhalb welcher ein spinpolarisierter elektrischer Strom zirkuliert, um ein oszillierendes Signal auf einer Ausgangselektrode zu erzeugen, wobei diese Vorrichtung aus einer Stapelung magnetischer und nicht magnetischer Schichten gebildet ist,
    • eine Stromquelle, um einen Gleichstrom von Elektronen in den Schichten senkrecht zu diesen zirkulieren zu lassen, und/oder einen Generator (70) eines magnetischen Gleichfelds, wobei der Elektronengleichstrom und/oder das magnetische Gleichfeld derart eingestellt sind, dass die von Oszillationen freie Frequenz $f_{lo}$ des oszillierenden Signals bei Abwesenheit eines Signals auf der Synchronisationsklemme auf $\pm$ 60 % genau gleich der Frequenz $\alpha f_t$ ist, wobei $\alpha$ eine positive rationale Zahl ist,

- die automatische Unterscheidung (130) des synchronisierten Zustands von dem nicht synchronisierten Zustand ausgehend von dem oszillierenden Signal, das von diesem Hochfrequenzoszillator erzeugt wird, wobei der synchronisierte Zustand ein Zustand ist, bei dem die Leistung von Niederfrequenzkomponenten des oszillierenden Signals, das von dem Hochfrequenzoszillator erzeugt wird, kleiner ist als ein vorbestimmter Leistungsschwellenwert, und der nicht synchronisierte Zustand ein Zustand ist, bei dem die Leistung dieser Niederfrequenzkomponenten des oszillierenden Signals, das von dem Hochfrequenzoszillator erzeugt wird, größer ist als dieser Leistungsschwellenwert, wobei die Niederfrequenzkomponenten eine Frequenz kleiner als 1 GHz haben, und
- die Anzeige der Gegenwart von Oszillationen in dem Frequenzband um die Frequenz $f_t$ in dem Signal e(t) als Reaktion auf den synchronisierten Zustand und, abwechselnd, im gegenteiligen Fall die Anzeige des Fehlens von Oszillationen in diesem Frequenzband in diesem Signal e(t).

**8.** Verfahren nach Anspruch 7, bei dem $\alpha$ aus der Gruppe ausgewählt wird, die zusammengesetzt ist aus 1/2; 3/4; 1; 3/2; 5/2; 2; 3; 4 und 7/2.

**9.** Verfahren nach Anspruch 7 oder 8, bei dem das Signal e(t) derart verstärkt ist, dass die Weite des Bands um die freie Frequenz $f_t$ der Frequenzen, mit welchen sich der Hochfrequenzoszillator synchronisieren kann, die Frequenz $f_t$ enthält.

**10.** Verfahren nach einem der Ansprüche 7 bis 9, bei dem das elektrische Signal e(t) derart verstärkt ist, dass seine Stärke auf der Synchronisationsklemme 10 % größer ist als die Stärke des Gleichstroms oder einem magnetischen Wechselfeld größer als 1 Oe im Inneren der freien Schicht entspricht, wenn es von einem Generator in ein Magnetfeld umgewandelt wird.

**Claims**

**1.** An oscillation detector for detecting oscillations in a frequency band around a first frequency $f_t$ in a received radio-frequency electrical signal e(t), said detector comprising:

- an acquisition terminal (10) for receiving said signal e(t), and
- a radio-frequency oscillator (22; 160), comprising:

    • at least one magnetoresistive device (40) within which flows a spin-polarised electrical current for generating an oscillating signal at an output electrode (24), said device being formed by a stack of magnetic and non-magnetic layers,

**characterised in that**:

- the radio-frequency oscillator, designed to synchronise with the frequency $f_t$, comprises

• a synchronisation terminal (20) for synchronising the frequency of the oscillating signal with a frequency of the signal received at said terminal, said terminal being connected to the acquisition terminal, and

• a current source (60) to cause a continuous current of electrons to flow perpendicularly through said layers and/or a continuous magnetic field generator (70), the continuous current of electrons and/or the continuous magnetic field being set so that the free frequency $f_{lo}$ of oscillations of the oscillating signal produced in absence of a signal at the synchronisation terminal is, within $\pm 60$ %, equal to the frequency $\alpha f_t$, where $\alpha$ is a positive rational number,

- an electronic comparator (28; 146) capable:

• of automatically distinguishing a synchronised state of the radio-frequency oscillator from a non-synchronised state of said radio-frequency oscillator on the basis of the oscillating signal produced by said radio-frequency oscillator, said synchronised state being a state in which the power of low-frequency components of the oscillating signal produced by the radio-frequency oscillator is below a predetermined power threshold, and the non-synchronised state being a state in which the power of these low-frequency components of the oscillating signal produced by the radio-frequency oscillator is above this predetermined power threshold, the low-frequency components having a frequency below 1 GHz, and

• of indicating the presence of oscillations, in the frequency band around the frequency $f_t$, in the signal e (t) in response to the synchronised state and, alternately, of indicating the absence of oscillation in this frequency band in the signal e(t) otherwise.

2. The detector according to Claim 1, wherein the comparator (28) is designed:

- to compare the power of low-frequency components of the oscillating signal produced by the radio-frequency oscillator with a predetermined power threshold, the low-frequency components having a frequency below 1 GHz, and

- to indicate the presence of oscillations in the frequency band around the frequency $f_t$ in the signal e(t) if the power of the low-frequency components is below this predetermined threshold and, if not, to indicate absence of such oscillations in the signal e(t).

3. The detector according to Claim 2, wherein the comparator comprises:

- at least one first capacitor ($C_1$, $C_2$),
- at least one controllable switch (92, 94), which is switchable between:

• a charged state in which the output electrode (24; 144) of said at least one radio-frequency oscillator is electrically connected to the capacitor, and

• a reading state in which the capacitor ($C_1$, $C_2$) is connected to a device for indicating its charge and the output electrode of said at least one radio-frequency oscillator is electrically isolated from this capacitor, and

- a clock (108) connected to the switch to automatically control switching of said switch between the two states.

4. The detector according to Claim 1, wherein the detector comprises:

- a common synchronisation terminal (142) intended to receive the signal e(t),
- a common output electrode (144),
- a plurality of magnetoresistive devices (22), each of which is designed to synchronise with the oscillations of frequency $f_t$, the synchronisation terminal (20) of each radio-frequency oscillator being connected to the common synchronisation terminal (142) to receive the same signal e(t), and the output electrode (24) of each radio-frequency oscillator being connected to the common output electrode (144) so that the oscillating signals produced by each of the radio-frequency oscillators are superimposed on the common output electrode, and

- the comparator (146) is able to distinguish between the synchronised state and the non-synchronised state based on the oscillating signal obtained at the common output electrode.

5. The detector according to any one of the preceding claims, wherein the stack of layers of the magnetoresistive device comprises at least the following layers:

  - an input electrode (42) by which a direct electrical current is injected,
  - a first magnetic layer (44), referred to as a "reference layer", capable of spin-polarising the electrical current and having a magnetisation of fixed direction,
  - a second magnetic layer (46), referred to as a "free layer", having a magnetisation that can oscillate when a spin-polarized current crosses said layer,
  - a non-magnetic layer (48), referred to as a "spacer", interposed between the two aforementioned layers to form a tunnel junction or a spin valve, and
  - an output electrode (50), at which is produced the signal oscillating at an oscillation frequency as a function of the intensity of the direct current or the amplitude of a continuous magnetic field having field lines that cross the free layer,
  - the cross-section of at least one of the layers in this stack has a diameter of less than 300 nm.

6. The detector according to Claim 5, wherein the radio-frequency oscillator comprises a magnetic field generator (70; 162) capable of generating a continuous magnetic field having field lines that cross the free layer with an intensity greater than or equal to 1 Oe.

7. A method for detecting oscillations in a frequency band around a first frequency $f_t$ in a received radio-frequency electrical signal e(t), **characterised in that** this method comprises the following steps:

  - receiving (126) the signal e (t) at a synchronisation terminal of a radio-frequency oscillator designed to synchronise with the frequency $f_t$, this radio-frequency oscillator comprising, in addition to this terminal:

    • at least one magnetoresistive device within which flows a spin-polarised electrical current for generating an oscillating signal at an output electrode, said device being formed by a stack of magnetic and non-magnetic layers,
    • a current source to cause a continuous current of electrons to flow in said layers in a direction perpendicular thereto and/or a continuous magnetic field generator (70), the continuous current of electrons and/or the continuous magnetic field being set so that the free frequency $f_{lo}$ of oscillations of the oscillating signal produced in absence of a signal at the synchronisation terminal is, within $\pm 60$ %, equal to the frequency $\alpha f_t$, where $\alpha$ is a positive rational number,

  - automatically distinguishing (130) a synchronised state from a non-synchronised state on the basis of the oscillating signal produced by this radio-frequency oscillator, the synchronised state being a state in which the power of low-frequency components of the oscillating signal produced by the radio-frequency oscillator is below a predetermined power threshold, and the non-synchronised state being a state in which the power of these low-frequency components of the oscillating signal produced by the radio-frequency oscillator is above this predetermined power threshold, the low-frequency components having a frequency below 1 GHz, and
  - of indicating the presence of oscillations, in the frequency band around the frequency $f_t$, in the signal e(t) in response to the synchronised state and, alternately, of indicating the absence of oscillation in this frequency band in this signal e(t) otherwise.

8. The method according to Claim 7, wherein $\alpha$ is selected from the group formed by 1/2; 3/4; 1; 3/2; 5/2; 2; 3; 4 and 7/2.

9. The method according to Claim 7 or 8, wherein the signal e(t) is amplified such that the extent of the band of frequencies, around the free frequency $f_t$, with which the radio-frequency oscillator can synchronise includes the frequency $f_t$.

10. The method according to any one of Claims 7 to 9, wherein the electrical signal e(t) is amplified such that its intensity at the synchronisation terminal is greater than 10 % of the intensity of the continuous current or corresponds to an alternating magnetic field greater than 1 Oe within the free layer when converted into a magnetic field by a generator.

Fig. 1

Fig. 2

Fig. 3

Fig. 4

Fig. 5

Fig. 6

Fig. 7

Fig. 8

Fig. 9

Fig. 10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2003193325 A
- US 2008150643 A
- US 5695864 A
- EP 1860769 A
- FR 2892871
- FR 0957888
- FR 2817998

**Littérature non-brevet citée dans la description**

- **ZARUDNIEV M.** Spintorque Oscillator Characteristics in coupled Networks. *Hardware and Software implementation and control of distributed MEMS (DMEMS), 2010 First workshop on, IEEE, Piscataway, NJ, USA,* 28 Juin 2010, 23-23
- **BAIBICH, M. ; BROTO, J.M. ; FERT, A. ; NGUYEN VAN DAU, F. ; PETROFF, F. ; ETIENNE, P. ; CREUZET, G. ; FRIEDERCH, A. ; CHAZELAS, J.** Giant magnetoresistance of (001)Fel(001)Cr magnetic superlattices. *Phys.Rev.Lett.,* 1988, vol. 61, 2472
- **MOODERA, JS. ; KINDER, LR. ; WONG, TM. ; MESERVEY,R.** Large magnetoresistance at room temperature in ferromagnetic thin film tunnel junctions. *Phys.Rev.Lett,* 1995, vol. 74, 3273-6
- **KATINE, J.A. ; ALBERT, F.J. ; BUHRMAN, R.A. ; MYERS, E.B. ; RALPH, D.C.** Current-Driven Magnetization Reversal and Spin-Wave Excitations in Co /Cu /Co Pillars. *Phys.Rev.Lett.,* 2000, vol. 84, 3149
- **KISELEV, S.I. ; SANKEY, J.C. ; KRIVOROTOV, LN. ; EMLEY, N.C. ; SCHOELKOPF, R.J. ; BUHRMAN, R.A. ; RALPH, D.C.** Microwave oscillations of a nanomagnet driven by a spin-polarized current. *Nature,* 2003, vol. 425, 380
- **SERGEI URAZHDIN ; PHILLIP TABOR.** Franctional synchronization of spin-torque nano-oscillators. *Physical review letters,* 03 Septembre 2010, vol. 105, 104101
- **A. SLAVIN ; V. TIBERKEVICH.** Nonlinear auto-oscillator theory of microwave generation by spin-polarized current. *IEEE Transaction on magnetics,* 2009, vol. 45, 1875-1918